# EUROPÄISCHE PATENTANMELDUNG

(11) **EP 3 214 644 A2**
(43) Veröffentlichungstag der Anmeldung: **06.09.2017**
(21) Anmeldenummer: 17155432.2
(22) Anmeldetag: 09.02.2017
(51) Int. Cl.: H01L 21/58, B32B 7/14

(54) **KLEBEVERFAHREN ZUM VERBINDEN ZWEIER WAFER MITTELS EINER STRUKTURIERTEN DOPPELKLEBESCHICHT**

(30) Priorität: 12.02.2016 DE 102016202174
(71) Anmelder: Fraunhofer-Gesellschaft zur Förderung der angewandten Forschung e.V., 80686 München (DE)
(72) Erfinder: Zoschke, Kai, 13089 Berlin (DE); Töpper, Michael, 13507 Berlin (DE)
(74) Vertreter: Pfenning, Meinig & Partner mbB

(57) **Zusammenfassung**

Die vorliegende Anmeldung umfasst ein Klebeverfahren zum Verbinden eines ersten Wafers (101) und eines zweiten Wafers (401, 501), wobei zunächst eine erste Klebeschicht (102) auf eine Oberfläche des ersten Wafers (101) aufgetragen wird. Weiterhin wird eine zweite Klebeschicht (201) auf die erste Klebeschicht (102) aufgetragen und die beiden Klebeschichten (102, 201) werden durch selektives Entfernen beider Klebeschichten (102, 201) in mindestens einem vorgegeben Bereich des ersten Wafers (101) strukturiert. Weiterhin wird der erste Wafer (101) mit dem zweiten Wafer (401, 501) durch Drücken einer Oberfläche des zweiten Wafers (401, 501) auf die (strukturierte) zweite Klebeschicht (302, 402, 502) verbunden, wobei die zweite Klebeschicht (402, 502) beim Verbinden des ersten Wafers (101) mit dem zweiten Wafer (401, 501) fließfähiger als die erste Klebeschicht (301) ist. Das Verfahren kann weiterhin ein zumindest teilweises Aushärten der ersten Klebeschicht (102) vor dem Auftragen der zweiten Klebeschicht (201) umfassen. Die erste und zweite Klebeschicht (102, 201) können aus demselben Material in unterschiedlichen Aushärtungsstufen oder aus unterschiedlichen Materialien bestehen. Die erste und/oder zweite Klebeschicht (102, 201) können auf der dem ersten Wafer (101) abgewandten Seite planar sein. Auf der Oberfläche des zweiten Wafers (501) ist optional eine Oberflächentopographie vorhanden, wobei die zweite Klebeschicht (201, 502) mindestens so dick wie der höchste Punkt (503) der Oberflächentopographie aufgetragen wird.

## Beschreibung

Die vorliegende Schutzrechtsanmeldung betrifft ein Verfahren zum Verbinden eines ersten und eines zweiten Wafers, wobei die beiden Wafer mittels einer strukturierten Doppelklebeschicht verbunden werden.

Für die Herstellung einiger mikroelektronischer Komponenten müssen Schaltungsträger oder Substrate wie Silizium-, Glas oder Keramikwafer durch Klebeschichten miteinander verbunden werden. Diese Klebeschichten werden typischerweise zunächst als ganzflächige Schicht auf einen der beiden zu verbindenden Wafer aufgebracht und, falls notwendig, dort strukturiert, beispielsweise durch ein fotolithographisches Strukturierungsverfahren. Das Verbinden bzw. der Fügeprozess, basiert dann auf einem Aufeinanderdrücken der beiden zu verbindenden Wafer und damit verbundenem Ausübens von Druck auf die zwischen den Wafern befindliche Klebeschicht. Zusätzlich kann beim Verbinden noch erhöhte Temperatur zum Einsatz kommen, durch welche die Klebeschicht plastisch verformt wird und sich zur Etablierung von einschlussfreien Verbindungen der Oberflächentopografie der Wafer möglichst gut angleicht.

Zur Ermöglichung derartiger Fügeverfahren muss die Klebeschicht auch nach ihrer Strukturierung eine gewisse Fließfähigkeit aufweisen, die es ermöglicht, das Material bei Druckausübung in die vorliegende Oberflächentopografie einzupressen und diese auszugleichen. Ist die Fließfähigkeit der Klebeschicht zu hoch und/oder die Klebeschicht zu dick, kann es jedoch zu Relativbewegungen zwischen den Wafern kommen. Hierbei besteht die Gefahr, dass sich bei starker Relativbewegung die erzeugte Klebestruktur der strukturierten Klebeschicht stark verformt oder gar vollständig zerstört wird.

Sollen zur Herstellung eines bestimmten Abstands zwischen den zu verbindenden Wafern, beispielsweise zum Ausgleich von Oberflächentopografien eines oder beider Wafer, Klebestrukturen einer gewissen Höhe von beispielsweise mehreren Mikrometern oder mehr erzeugt werden, so stellt sich dies bei Verwendung eines gut fließfähigen Materials als schwierig dar, da sich die Klebestrukturen beim Verbinden somit verformen, was eine zu niedrige Klebehöhe und/oder verwischte Klebestrukturen zur Folge hat.

Weiterhin ist es bei einigen polymerbasierten Materialien schwierig, eine hinreichende Fließfähigkeit nach der Strukturierung zu gewährleisten. Bei der Strukturierung geht das Material häufig von einem unvernetzten Zustand in einen vernetzten Zustand über und/oder die Glasübergangtemperatur steigt an. Außerdem werden fotoempfindliche Polymere durch die Belichtung im Rahmen eines fotolithografischen Strukturierungsverfahrens vorpolymerisiert, was eine reduzierte Fließfähigkeit zur Folge hat. Nicht fotoempfindliche Polymere werden vor ihrer Strukturierung, die beispielsweise mittels Trockenätzung erfolgen kann, polymerisiert, was ebenfalls eine reduzierte Fließfähigkeit der Strukturen bedingt. Auch wird durch die zumindest teilweise Polymerisierung die Klebfähigkeit des Polymers eingeschränkt.

Aus dem Stand der Technik sind Verfahren bekannt, bei denen zur Herstellung strukturierter Klebeschichten mit einer gewissen, vorgegebenen Stärke, zunächst Erhöhungen vorprozessiert werden, beispielsweise aus Silizium, Glas oder ausgehärteten Polymeren. Diese Erhöhungen, oder Sockelstrukturen, sind nicht oder nur schwer verformbar und können mit einem herkömmlichen Strukturierungsverfahren, beispielsweise fotolithografisch oder durch Ätzen erzeugt werden. Diese nach der Strukturierung verbleibenden Sockelstrukturen, die im Vergleich zur unstrukturierten Schicht nur eine geringe Fläche des Wafers bedecken, werden dann mit einer dünnen, gut fließfähigen Klebeschicht, auch als Deckschicht bezeichnet, beschichtet. Diese Beschichtung erfolgt beispielsweise durch Transfertechniken wie Abstempeln eines Klebers von einem beschichteten Hilfswafer oder von einer beschichteten Rolle oder auch durch Besprühen der Sockelstruktur mit dem Klebermaterial. Durch die geeignete Proportionierung von fester Sockelstruktur und gut fließfähiger Deckschicht wird eine Struktur geschaffen, die eine zu starke laterale Verpressung der Kleberschicht vermeidet und gleichzeitig einen Ausgleich der Oberflächentopografie im erforderlichen Maß zulässt.

Bei den aus dem Stand der Technik bekannten Verfahren ist es somit notwendig, dass die Sockelstrukturen zunächst vorprozessiert und strukturiert werden, bevor die Deckschicht aus gut fließfähigem Klebstoff aufgetragen wird. Dies ist sehr aufwendig.

Die vorliegende Anmeldung stellt ein hierzu alternatives, vereinfachtes Verfahren bereit, entsprechend dem Hauptanspruch. Vorteilhafte Weiterentwicklungen und Varianten sind durch die abhängigen Ansprüche beschrieben.

Das beanspruchte Klebeverfahren zum Verbinden eines ersten und eines zweiten Wafers umfasst das Auftragen einer ersten Klebeschicht auf eine Oberfläche des ersten Wafers. Die erste Klebeschicht kann hierbei durch Standardverfahren wie beispielsweise Aufschleudern, Rakeln, Laminieren oder Sprühen erfolgen. Die erste Klebeschicht kann eine vorgegebene Höhe von beispielsweise zwischen 0,5 und 50µm, vorzugsweise zwischen 1 und 20 µm, besonders bevorzugt zwischen 5 und 10 µm haben.

Die erste Klebeschicht kann flächig auf der gesamten Oberfläche des ersten Wafers aufgetragen werden oder auf einer, vorzugsweise zusammenhängenden, Teilfläche der Oberfläche des ersten Wafers aufgetragen werden. Beispielsweise kann ein Rand beim Auftragen der ersten Klebeschicht ausgespart werden.

In einem weiteren Verfahrensschritt wird eine zweite Klebeschicht auf die erste Klebeschicht aufgetragen. Das Auftragen der zweiten Klebeschicht kann beispielsweise ebenfalls mittels der im vorher gehenden Absatz genannten Standardverfahren erfolgen. Die zweite Klebeschicht kann ebenfalls eine vorgegebene Höhe haben, die vorzugsweise deutlich geringer als die Höhe der ersten Klebeschicht ist, beispielsweise höchstens halb so hoch wie die erste Klebeschicht oder vorzugsweise maximal 20% der Höhe der ersten Klebeschicht. Beispielsweise kann die zweite Klebeschicht eine Höhe von weniger als 2µm, vorzugsweise zwischen 0,5 - 1 µm haben.

Die zweite Klebeschicht kann flächig auf die erste Klebeschicht aufgetragen werden, so dass die zweite Klebeschicht die erste Klebeschicht vollständig bedeckt, oder die zweite Klebeschicht kann auf eine, vorzugsweise zusammenhängende Teilfläche der ersten Klebeschicht aufgetragen werden.

Die erste und/oder die zweite Klebeschicht können hierbei vorzugsweise aus einem für adhäsive Bondprozesse geeignetem Material, beispielsweise aus Benzocyclobuten (BCB) oder einem anderen Polymer, bestehen.

In einem weiteren Verfahrensschritt werden die beiden Klebeschichten durch selektives Entfernen beider Klebeschichten in mindestens einem vorgegebenen Bereich des ersten Wafers strukturiert.

Die Strukturierung kann beispielsweise durch einen Laser, wie einen Excimerlaser oder einen anderen ablativen Laser erfolgen. Weiterhin eignen sich andere Strukturierungsverfahren, die vorzugsweise zur Strukturierung von Klebstoffen mit hoher Fließfähigkeit geeignet sind zur gemeinsamen Strukturierung der ersten und zweiten Klebeschicht.

Durch die Strukturierung der Klebeschicht können selektiv Flächen des ersten Wafers freigelegt werden. Die kann für die weitere Verarbeitung verschiedene Vorteile haben. Beispielsweise kann somit ein späteres Lösen der Klebeverbindung oder ein Vereinzeln der auf dem Wafer befindlichen Bauelemente vereinfacht werden. Die gemeinsame Strukturierung beider Klebeschichten vereinfacht weiterhin das Erstellen der Doppelklebeschicht, da beide Klebeschichten flächig durch dieselben Apparaturen aufgetragen werden können. Somit können durch eine gemeinsame Strukturierung die Kosten gesenkt werden.

In einem weiteren Verfahrensschritt wird der erste Wafer mit dem zweiten Wafer durch Drücken einer Oberfläche des zweiten Wafers auf die zweite Klebeschicht verbunden. Das auch als Fügen bezeichnete Verbinden der beiden Wafer kann durch Druck auf die beiden zu verbindenden Wafer erfolgen und/oder zusätzlich durch Wärmezufuhr oder UV Belichtung unterstützt werden.

Beim Verbinden der beiden Wafer ist die zweite Klebeschicht fließfähiger als die erste Klebeschicht, wodurch lediglich die zweite Klebeschicht nennenswert verläuft und somit die Struktur der Klebeschichten weitgehend erhalten bleibt. Durch die gute Fließfähigkeit der zweiten Klebeschicht beim Verbinden der beiden Wafer kann zudem eine gute Klebfähigkeit und somit eine stabile Verbindung der beiden Wafer erreicht werden.

Vorzugsweise ist die zweite Klebeschicht wesentlich dünner als die erste Klebeschicht, beispielsweise beträgt die Stärke der zweiten Klebeschicht gegenüber der ersten Klebeschicht vor dem Verbinden der beiden Wafer unter 50%, vorzugsweise unter 20% oder unter 10%.

Kommt es nun beim Fügen der beiden Wafer zu einem Verlaufen der fließfähigen zweiten Klebeschicht, so wird die zweite Klebeschicht beispielsweise am Rand der aus der ersten Klebeschicht entstandenen Sockelstrukturen ein bisschen herausgedrückt, oder ein Teil der zweiten Klebeschicht kann an den Seiten der Sockelstrukturen hinunterfließen. Allerdings ist die zweite Klebeschicht vorzugsweise so dünn gehalten, dass ein Verlaufen der zweiten Klebeschicht beispielsweise entlang der Sockelstruktur bis auf den ersten Wafer hinunter unwahrscheinlich bis ausgeschlossen ist. Somit bleiben die im Strukturierungsschritt erzeugten Strukturen zumindest annähernd vollständig erhalten.

Es ist weiterhin möglich, dass das Verfahren gemäß der vorliegenden Anmeldung einen weiteren Verfahrensschritt umfasst, bei dem vor dem Auftragen der zweiten Klebeschicht die erste Klebeschicht zumindest teilweise ausgehärtet wird. Das Aushärten kann hierbei durch Licht, Wärme oder ähnlichem, gemäß dem vorliegenden Material erfolgen. In diesem Fall wird dann die zweite Klebeschicht nach dem zumindest teilweisen Aushärten der ersten Klebeschicht, auf die teilweise ausgehärtete erste Klebeschicht aufgetragen, und die beiden Klebeschichten unterschiedlicher Fließfähigkeit und/oder Aushärtungsstufe werden anschließend gemeinsam strukturiert.

Vorzugsweise wird bei dem beschriebenen Verfahren also in der folgenden Reihenfolge vorgegangen:
Zuerst werden die beiden Klebeschichten entweder nacheinander oder gleichzeitig auf den ersten Wafer aufgetragen.

Vor dem Auftragen der zweiten Klebeschicht kann die erste Klebeschicht vorzugsweise zumindest teilweise ausgehärtet werden. Bei einem gemeinsamen Auftragen beider Klebeschichten kann die erste Klebeschicht bereits beim Auftragen zumindest teilweise ausgehärtet sein oder werden.

Danach werden die beiden Klebeschichten gleichzeitig und/oder gemeinsam strukturiert.

Nach dem Strukturieren der beiden Klebeschichten wird ein zweiter Wafer mit dem ersten Wafer durch Drücken des zweiten Wafers auf die zweite Klebeschicht verbunden. Zum Zeitpunkt des Verbindens der beiden Wafer ist die zweite Klebeschicht fließfähiger als die erste Klebeschicht.

Das gemeinsame Strukturieren der beiden Klebeschichten kann vorzugsweise durch Laserablation erfolgen, beispielsweise mit einem Excimerlaser zum Entfernen von Strukturen mit einer Genauigkeit von unter 2µm. Alternativ können auch andere Strukturierungsverfahren eingesetzt werden, die zum Strukturieren von Materialien mit hoher Fließfähigkeit und/oder zum gleichzeitigen Strukturieren von mehreren Schichten unterschiedlicher Fließfähigkeiten geeignet sind.

Es ist weiterhin möglich, dass die erste und zweite Klebeschicht gleichzeitig auf den ersten Wafer aufgetragen werden, beispielsweise durch Laminieren einer vorgefertigten zwei-lagigen Klebeschicht. Auch ist es möglich, dass mit dem Auftragen der zweiten Klebeschicht bereits begonnen wird bevor die erste Klebeschicht vollständig aufgetragen ist. Durch ein zumindest teilweise gleichzeitiges Auftragen der beiden Klebeschichten kann der Beschichtungsprozess vereinfacht und/oder beschleunigt werden.

Das Auftragen der ersten Klebeschicht auf den ersten Wafer und/oder das Auftragen der zweiten Klebeschicht auf die erste Klebeschicht erfolgt vorzugsweise gleichmäßig und/oder lückenlos. Ein gleichmäßiges und/oder lückenloses Auftragen kann durch die oben genannten Verfahren zum Auftragen einer Klebeschicht ermöglicht werden.

Eine gleichmäßig aufgetragene Klebeschicht kann insbesondere auf der dem ersten Wafer abgewandten Seite planar sein, wobei es möglich ist, dass die erste Klebeschicht bedingt durch eine Oberflächentopografie des ersten Wafers an zwei verschiedenen Stellen unterschiedliche Dicken aufweist. Die zweite Klebeschicht ist vorzugsweise auf beiden Seiten planar und hat somit vor der Strukturierung vorzugsweise eine konstante Dicke.

Es ist auch möglich, dass auf dem zweiten Wafer, auf der Seite die beim Verbinden mit der zweiten Klebeschicht in Kontakt kommt, eine Oberflächentopografie mit Erhöhungen zwischen 0,5 und 10µm vorhanden ist, und die zweite Klebeschicht mindestens so dick aufgetragen wird, dass beim Verbinden des ersten Wafers mit dem zweiten Wafer die Oberflächentopografie des zweiten Wafers vollständig von der zweiten, fließfähigen Klebeschicht umflossen werden kann. Gleichzeitig kann die erste, weniger fließfähige Klebeschicht eine Stopperstruktur bilden, die einen Mindestabstand zwischen den beidem Wafern gewährleistet.

Es ist möglich, dass die beiden Klebeschichten aus demselben Material in unterschiedlichen Aushärtungsstufen bestehen. Beispielsweise können beide Schichten aus BCB oder einem anderen Polymer bestehen, wobei die erste Klebeschicht nach dem Auftragen zumindest teilweise ausgehärtet wird, oder das Material kann bereits in unterschiedlichen Aushärtungsstufen aufgetragen werden. Bei Verwendung desselben Materials in unterschiedlichen Aushärtungsstufen bildet sich am Ende des Klebeverfahrens, nach dem Verbinden der beiden Wafer und vollständigem Aushärten beider Klebeschichten eine besonders homogene Klebeschicht.

Alternativ ist es möglich die erste und die zweite Klebeschicht aus unterschiedlichen Materialien zu fertigen. Auch hierbei ist es möglich, dass das Material der ersten Klebeschicht vor dem Auftragen der zweiten Klebeschicht zumindest teilweise ausgehärtet wird, oder dass das Material der ersten Klebeschicht bereits beim oder vor dem Auftragen eine gegenüber dem Material der zweiten Klebeschicht verringerte Fließfähigkeit aufweist.

Die Verwendung unterschiedlicher Materialien oder von Materialien, die bereits beim Auftragen verschiedene Fließfähigkeiten aufweisen kann das Auftrageverfahren vereinfachen und/oder beschleunigen, da beispielsweise auf einen Aushärteschritt verzichtet werden kann und/oder die Materialen zumindest teilweise gleichzeitig, wie oben beschrieben, aufgetragen werden können.

Das beschriebene Verfahren ist neben Wafern auch allgemeiner für Schaltungsträger, Substrate oder ähnliche Strukturen geeignet.

Weiterhin umfasst die vorliegende Schutzrechtsanmeldung eine Doppelklebeschicht, die wie oben beschrieben hergestellt wurde. Die Verwendung einer durch das beschriebene Verfahren hergestellten Doppelklebeschicht kann durch einen Querschliff des fertigen Produkts zumindest nahegelegt werden, wenn klare Strukturen und/oder verschiedene Klebematerialien erkennbar sind.

Weitere Ausführungsformen des beschriebenen Verfahrens sind nachfolgend anhand der Figuren beschrieben. Hierbei zeigen
- Figur 1a: eine Draufsicht eines mit einer ersten Klebeschicht beschichteten ersten Wafer,
- Figur 1b: ein Querschnitt des Gegenstands aus Figur 1a,
- Figur 2a: eine Draufsicht des zusätzlich mit einer zweiten Klebeschicht beschichteten Wafers aus Figur 1a,
- Figur 2b: ein Querschnitt des Gegenstands aus Figur 2a,
- Figur 3a: eine Draufsicht des Wafers aus Figur 2a nach einem Strukturierungsschritt,
- Figur 3b: ein Querschnitt des Gegenstands aus Figur 3a,
- Figur 4: ein Querschnitt des Wafers aus Figur 3b nach einem Verbinden mit einem zweiten Wafer und
- Figur 5: ein Querschnitt des Wafers aus Figur 3b nach dem Verbinden mit einem zweiten Wafer mit einer Oberflächentopografie.

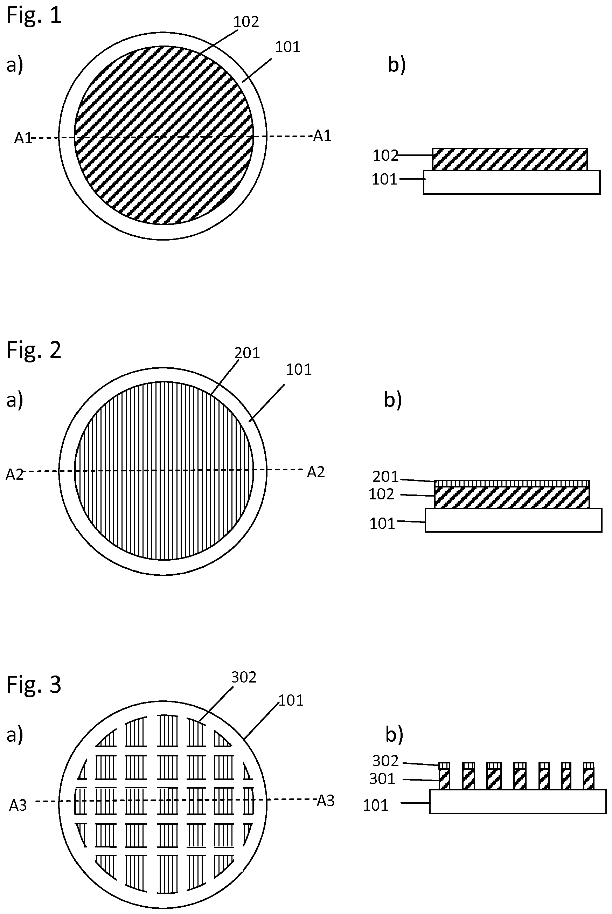

Figur 1 zeigt einen runden, ersten Wafer 101, der, unter Aussparung eines Randes, flächig mit einer ersten Klebeschicht 102 beschichtet ist. Die erste Klebeschicht 102 besteht aus einem Polymer und/oder Thermoplastmaterial, wie beispielsweise BCB, und wurde auf den ersten Wafer 101 durch Aufschleudern aufgetragen. Die erste Klebeschicht 102 ist somit auf der dem ersten Wafer 101 abgewandten Seite planar, kann aber bedingt durch Oberflächenstrukturen des ersten Wafers 101 unterschiedliche Stärken aufweisen. Die Stärke der ersten Klebeschicht 102 ist so gewählt, dass die Oberflächenstrukturen des ersten Wafers 101 vollständig bedeckt sind.

Figur 1b zeigt den ersten Wafer 101 sowie die erste Klebeschicht 102 gemäß Figur 1a im Querschnitt entlang der Linie A1. Hierbei ist erkennbar, dass die erste Klebeschicht 102 eine lückenlose und gleichmäßige Schicht, bildet, die auf der dem ersten Wafer 101 abgewandten Seite planar ist.

Nach dem Auftragen der ersten Klebeschicht 102 wird diese zumindest teilweise ausgehärtet und vorpolymerisiert. Dadurch verringert sich die Fließfähigkeit der ersten Klebeschicht 102.

Figur 2a zeigt das Zwischenprodukt nach dem nächsten Verfahrensschritt, bei dem eine zweite Klebeschicht 201 auf den beschichteten Wafer aus Figur 1a aufgetragen wurde. Die zweite Klebeschicht 201 ist wiederum gleichmäßig und lückenlos aufgetragen und bedeckt die erste Klebeschicht vollständig. Alternativ könnte die zweite Klebeschicht 201 auch nur auf einem einfach zusammenhängenden Teil der ersten Klebeschicht 102 gleichmäßig aufgetragen werden.

Wie im Querschnitt entlang der Linie A2 in Figur 2b erkennbar, ist die zweite Klebeschicht 201 auf beiden Seiten planar und hat somit eine konstante Dicke. Geringfügige, produktionsbedingte Abweichungen werden hierbei ebenfalls als planar im Sinne der vorliegenden Anmeldung erachtet. Die zweite Klebeschicht 201 ist außerdem deutlich dünner als die erste Klebeschicht 102.

Die zweite Klebeschicht 201 besteht ebenfalls aus BCB in unpolymerisiertem Zustand und weist dadurch eine höhere Fließfähigkeit als die bereits vorpolymerisierte erste Klebeschicht 102 auf.

Alternativ kann die zweite Klebeschicht auch aus einem anderen Thermoplastmaterial und/oder anderen Polymeren gefertigt werden.

Figur 3a zeigt das Zwischenprodukt nach einem weiteren Verfahrensschritt in dem beide Klebeschichten durch Laserablation strukturiert wurden. Hierbei werden mit einem Laser, beispielsweise einem Excimerlaser, selektiv und mit hoher Genauigkeit die Moleküle der Klebeschichten in vorgegebenen Bereichen des ersten Wafers angeregt und entfernt.

In der Draufsicht aus Figur 3a ist nur die strukturierte zweite Klebeschicht 302 erkennbar, während der in Figur 3b dargestellte Querschnitt entlang der Linie A3 die zweischichtigen Klebestrukturen zeigt, die aus einer strukturierten ersten Klebeschicht 301 sowie einer strukturierten zweiten Klebeschicht 302 bestehen.

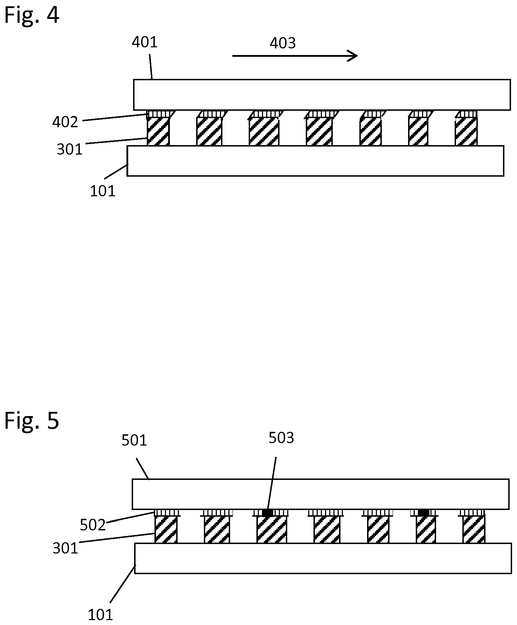

Figur 4 zeigt das Verbinden des beschichteten strukturierten Wafers der Figur 3 mit einem zweiten Wafer 401. Das Verbinden erfolgt bei erhöhter Temperatur durch Aufdrücken des zweiten Wafers 401 auf die zweite Klebeschicht 402, die durch das Aufdrücken zumindest leicht verformt wird. Es ist möglich, dass es beim Aufdrücken des zweiten Wafers 401 zu einer leichten lateralen Materialverpressung kommt und der zweite Wafer 401 durch die hohe Fließfähigkeit der zweiten strukturierten Klebeschicht 302, 402 in eine Richtung 403 verschoben wird. Durch die geringe Dicke der zweiten Klebeschicht 302 und die verminderte Fließfähigkeit der strukturierten ersten Klebeschicht 301 kommt es aber nur zu geringen Verschiebungen, da die strukturierte erste Klebeschicht 301 sich unter dem aufgebrachten Druck nicht oder nur sehr geringfügig verformt. Die Struktur der strukturierten Klebeschichten 301, 302 auf Figur 3 bleibt somit weitgehend erhalten, da nur geringe Mengen der zweiten Klebeschicht 302 durch den ausgeübten Druck verlaufen und gegebenenfalls an der durch die erste strukturierte Klebeschicht 301 definierte Sockelstruktur hinunterläuft.

In Figur 5 wird das Verbinden eines zweiten Wafers 501, der über eine Oberflächentopografie in Form von Erhöhungen 503 verfügt, mit dem in Figur 3 gezeigten strukturierten Wafer gezeigt. Hierbei kommt es ebenfalls zu einer geringfügigen Materialverpressung der strukturierten zweiten Klebeschicht 502. Die Dicke der zweiten Klebeschicht ist hierbei so gewählt, dass sie mindestens so dick wie die höchste Erhöhung 503 der Oberflächentopografie der zweiten Wafers 501 ist. Somit kann die Oberflächentopografie durch die zweite Klebeschicht vollständig umflossen und eingeschlossen werden, aber durch die festeren Sockelstrukturen der strukturierten ersten Klebeschicht bleibt die vorgegebene Struktur weitgehend erhalten.

Nach dem Verbinden der beiden Wafer werden beide Klebeschichten vollständig ausgehärtet. Die beiden Wafer sind somit permanent verbunden und können gemeinsam weiter verarbeitet werden. Ein späteres Trennen der beiden Wafer ist vorzugsweise nicht vorgesehen.

Nach dem Aushärten der beiden Klebeschichten ist eine Unterscheidung der verwendeten Schichten unter Umständen, insbesondere wenn für beide Klebeschichten dasselbe Material verwendet wurde, nur schwer oder gar nicht möglich. Auf eine Verwendung des hier beschriebenen Verfahrens können vor allem klare Strukturen einer ausgehärteten Klebeschicht zwischen zwei Wafern in Kombination mit leicht verlaufenen Strukturen an einem Ende der Klebeschicht hindeuten. Allerdings können ähnliche Merkmale der Klebeschicht auch aus anderen Verfahren zum Verbinden zweier Wafer resultieren.

## Patentansprüche

1. Klebeverfahren zum Verbinden eines ersten Wafers (101)und eines zweiten Wafers (401; 501), umfassend die folgenden Schritte:
- Auftragen einer ersten Klebeschicht (102) auf eine Oberfläche des ersten Wafers (101),
- Auftragen einer zweiten Klebeschicht (201) auf die erste Klebeschicht (102),
- Strukturieren der beiden Klebeschichten (301, 302) durch selektives Entfernen beider Klebeschichten in mindestens einem vorgegeben Bereich des ersten Wafers (101),
- Verbinden des ersten Wafers (101) mit dem zweiten Wafer (401;501) durch Drücken einer Oberfläche des zweiten Wafers (401;501) auf die zweite Klebeschicht (201),
wobei die zweite Klebeschicht (302) beim Verbinden des ersten Wafers (101) mit dem zweiten Wafer (401; 501) fließfähiger als die erste Klebeschicht (301) ist.

2. Verfahren gemäß Anspruch 1, weiterhin umfassend, vor dem Auftragen der zweiten Klebeschicht (201), ein zumindest teilweises Aushärten der ersten Klebeschicht (102).

3. Verfahren gemäß einem der vorhergehenden Ansprüche, wobei das Strukturieren zumindest teilweise durch Laserablation erfolgt.

4. Verfahren gemäß einem der Ansprüche 1 und 2, wobei die erste und/oder zweite Klebeschicht (102; 201) aus einem für adhäsive Fügeprozesse geeignetem Material, wie Benzocyclobuten oder einem anderen Polymer, besteht.

5. Verfahren gemäß einem der vorhergehenden Ansprüche, wobei die beiden Klebeschichten (102; 201) gleichzeitig aufgetragen werden.

6. Verfahren gemäß einem der vorhergehenden Ansprüche, wobei das Auftragen der ersten Klebeschicht (102) auf die Oberfläche des ersten Wafers (101) und/oder das Auftragen der zweiten Klebeschicht (201) auf die erste Klebeschicht (102) gleichmäßig und/oder lückenlos erfolgt.

7. Verfahren gemäß einem der vorhergehenden Ansprüche, wobei die erste und/oder zweite Klebeschicht (102; 201) auf der dem ersten Wafer (101) abgewandten Seite planar ist.

8. Verfahren gemäß einem der vorhergehenden Ansprüche, wobei auf der Oberfläche des zweiten Wafers (501) eine Oberflächentopographie vorhanden ist und die zweite Klebeschicht (201) mindestens so dick wie der höchste Punkt (503) der Oberflächentopographie aufgetragen wird.

9. Verfahren gemäß einem der vorhergehenden Ansprüche, wobei die erste und die zweite Klebeschicht (102; 201) aus demselben Material in unterschiedlichen Aushärtungsstufen bestehen.

10. Verfahren gemäß einem der Ansprüche 1 - 7, wobei die erste und die zweite Klebeschicht (102; 201) aus unterschiedlichen Materialien bestehen.

11. Strukturierte Doppelklebeschicht, hergestellt nach dem Verfahren gemäß einem der vorhergehenden Ansprüche.
